# EUROPEAN PATENT SPECIFICATION

(11) **EP 4 013 028 B1**
(45) Date of publication and mention of the grant of the patent: **02.09.2026**
(21) Application number: 20851897.7
(22) Date of filing: 29.07.2020
(51) Int. Cl.: H04M 1/02, H04N 5/222, G01B 11/25, G02B 7/02, G02B 13/00, G03B 21/00, G02B 27/42, H04N 23/45, H04N 23/51, H04N 23/55, H04N 23/56, H04N 23/57, H10F 39/00, H10W 90/00

(54) **LASER PROJECTOR, DEPTH CAMERA, AND ELECTRONIC APPARATUS**
LASERPROJEKTOR, TIEFENKAMERA UND ELEKTRONISCHES GERÄT
PROJECTEUR LASER, CAMÉRA DE PROFONDEUR ET APPAREIL ÉLECTRONIQUE

(30) Priority: 14.08.2019 CN 201910750130
(43) Date of publication of application: 15.06.2022
(73) Proprietor: GUANGDONG OPPO MOBILE TELECOMMUNICATIONS CORP., LTD., Dongguan, Guangdong 523860 (CN)
(72) Inventor: ZHANG, Xueyong, Dongguan, Guangdong 523860 (CN); LYU, Xiangnan, Dongguan, Guangdong 523860 (CN)
(74) Representative: Thorniley, Peter
(86) International application number: PCT/CN2020/105482
(87) International publication number: WO 2021/027573

(56) References cited:
- EP-A1- 2 966 503
- EP-A1- 3 462 128
- CN-A- 108 226 948
- CN-A- 108 490 636
- CN-A- 108 490 636
- CN-A- 108 646 425
- CN-A- 109 521 639
- CN-A- 109 709 756
- CN-A- 110 058 424
- CN-A- 110 505 380
- US-A1- 2005 133 723
- US-A1- 2019 041 659
- US-B1- 10 312 656

## Description

### TECHNICAL FIELD

The present disclosure relates to the field of depth information obtaining technologies, and more particularly, to a laser projector, a depth camera, and an electronic device.

### BACKGROUND

A depth collecting device may be mounted in a mobile phone. The depth collecting device is generally arranged on a front surface of the mobile phone as a front camera. The depth collecting device can also be arranged on a rear surface of the mobile phone as a rear camera. US2019041659A1 discloses a structured light generation device including a laser light source module and a diffractive optical element, in which no collimator is between the laser light source module and the diffractive optical element, the spacing distance between the laser light source module and the diffractive optical element is shortened, and thus the overall structured light generation device is slim. CN109521639A discloses a structured light projection module without a collimating lens and a 3D imaging device having the same, which can effectively increase the structural compactness and the light energy utilization rate of the module. CN108490636A discloses a structured light projector, photoelectric equipment and an electronic device, which can reduce the energy of the zero-level beam and facilitate the structured light projector to project a laser pattern with better brightness uniformity. EP3462128A1 discloses a camera system configured to generate depth information for a local area. US20050133723A1 disclose a SiGe surface-normal optical path photodetector structure and a method for forming the SiGe optical path normal structure.

### SUMMARY

Embodiments of the present disclosure provide a laser projector, a depth camera, and an electronic device. The invention is set out in the appended set of claims.

In the laser projector, the depth camera, and the electronic device according to the embodiments of the present disclosure, a divergent angle of each of the plurality of light-emitting units is smaller than 20 degrees, and light projected by the diffraction assembly has a relatively small divergent angle, in such a manner that an energy density of the light projected onto a distant target object will not be too small and will not be easily interfered, thereby finally obtaining accurate depth information.

Additional aspects and advantages of the embodiments of the present disclosure will be given at least in part in the following description, or become apparent at least in part from the following description, or can be learned from practicing of the embodiments of the present disclosure.

### BRIEF DESCRIPTION OF DRAWINGS

The above and/or additional aspects and advantages of the present disclosure will become more apparent and more understandable from the following description of the embodiments taken in conjunction with the accompanying drawings, in which:
FIG. 1 is a schematic diagram showing a structure of an electronic device according to an embodiment of the present disclosure;
FIG. 2 is a schematic diagram showing a structure of a depth camera according to an embodiment of the present disclosure;
FIG. 3 is a three-dimensional assembly diagram of a laser projector according to an embodiment of the present disclosure;
FIG. 4 is a three-dimensional exploded diagram of a laser projector according to an embodiment of the present disclosure;
FIG. 5 is a schematic sectional view of the laser projector illustrated in FIG. 3 taken along line V-V;
FIG. 6 is a schematic diagram showing a structure of a light source according to an embodiment of the present disclosure;
FIG. 7 and FIG. 8 are schematic diagrams showing a principle of laser emission of a laser projector according to an embodiment of the present disclosure;
FIG. 9 is a schematic diagram showing a structure of an image collector according to an embodiment of the present disclosure;
FIG. 10 is a schematic optical path diagram of an image collector collecting a laser pattern by using a first optical path according to an embodiment of the present disclosure;
FIG. 11 is a schematic optical path diagram of an image collector collecting a laser pattern by using a second optical path according to an embodiment of the present disclosure;
FIG. 12 is a schematic diagram showing a structure of a reflection-transmission prism according to an embodiment of the present disclosure;
FIG. 13 is a schematic sectional view of the reflection-transmission prism illustrated in FIG. 12 taken along line XIII-XIII; and
FIG. 14 is a schematic diagram showing a structure of a photosensitive member according to an embodiment of the present disclosure.

### DESCRIPTION OF EMBODIMENTS

The embodiments of the present disclosure will be further described below with reference to the accompanying drawings, throughout which same or similar elements, or elements having same or similar functions, are denoted by same or similar reference signs.

In addition, the embodiments of the present disclosure described below with reference to the drawings are illustrative only, and are intended to explain rather than limiting the embodiments of the present disclosure.

In the present disclosure, unless expressly stipulated and defined otherwise, the first feature being "on" or "under" the second feature may mean that the first feature is in direct contact with the second feature, or the first and second features are in indirect contact through an intermediate. Moreover, the first feature being "above" the second feature may mean that the first feature is directly above or obliquely above the second feature, or simply mean that the level of the first feature is higher than that of the second feature. The first feature being "below" the second feature may mean that the first feature is directly below or obliquely below the second feature, or simply mean that the level of the first feature is smaller than that of the second feature.

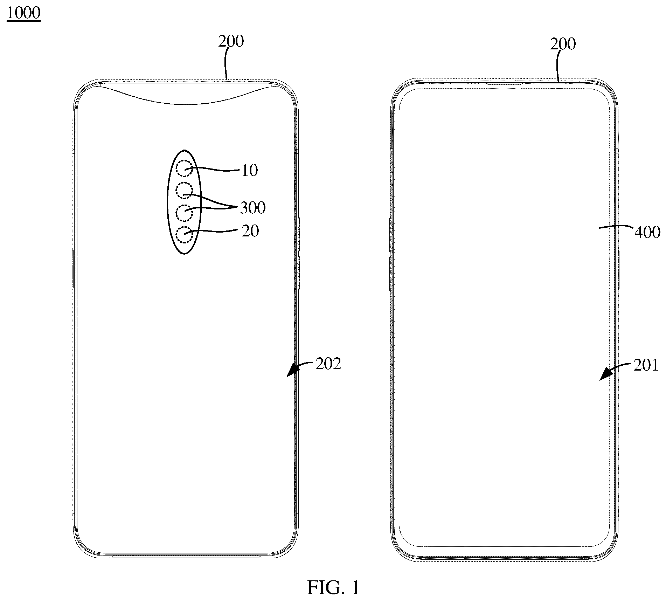

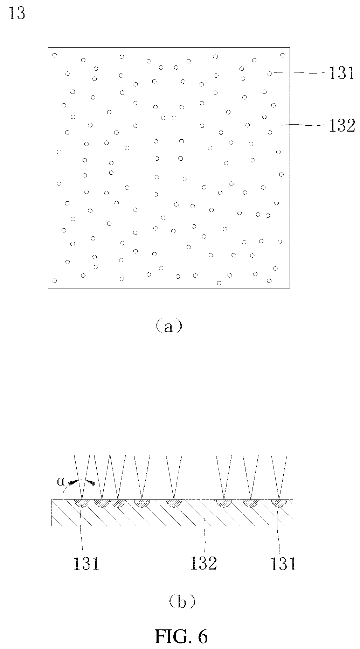

Referring to FIG. 1 to FIG. 4, an electronic device 1000 according to the embodiments of the present disclosure includes a housing 200 and a depth camera 100. The depth camera 100 is mounted on the housing 200, and includes a laser projector 10 and an image collector 20. The laser projector 10 includes a substrate 11, a lens barrel 12, a light source 13, and a diffraction assembly 15. The lens barrel 12 is arranged on the substrate 11, and the lens barrel 12 and the substrate 11 define an accommodating chamber 121. The light source 13 is arranged on the substrate 11 and located in the accommodating chamber 121, and the light source 13 includes a plurality of light-emitting units 131 (as illustrated in FIG. 6). A divergent angle of each of the plurality of light-emitting units 131 (e.g., an angle α as illustrated in FIG. 6) is smaller than 20 degrees. The diffraction assembly 15 is mounted on the lens barrel 12 and located on an optical path of the light source 13. The image collector 20 is configured to collect a laser pattern projected by the laser projector 10 onto a target object and reflected by the target object.

When a depth collecting device is arranged on a rear surface of a mobile phone and used as a rear camera, because of a generally long shooting distance, light emitted by the depth collecting device has a weak energy density when acting on a target object, and may be easily interfered, resulting in inaccuracy of finally-obtained depth information.

In the laser projector 10, the depth camera 100, and the electronic device 1000 according to the embodiments of the present disclosure, a divergent angle of each of the plurality of light-emitting units 131 is smaller than 20 degrees, and light passing through and projected by the diffraction assembly 15 has a relatively small divergent angle, in such a manner that an energy density of the light projected onto a distant target object will not be too small and will not be easily interfered, thereby finally obtaining accurate depth information.

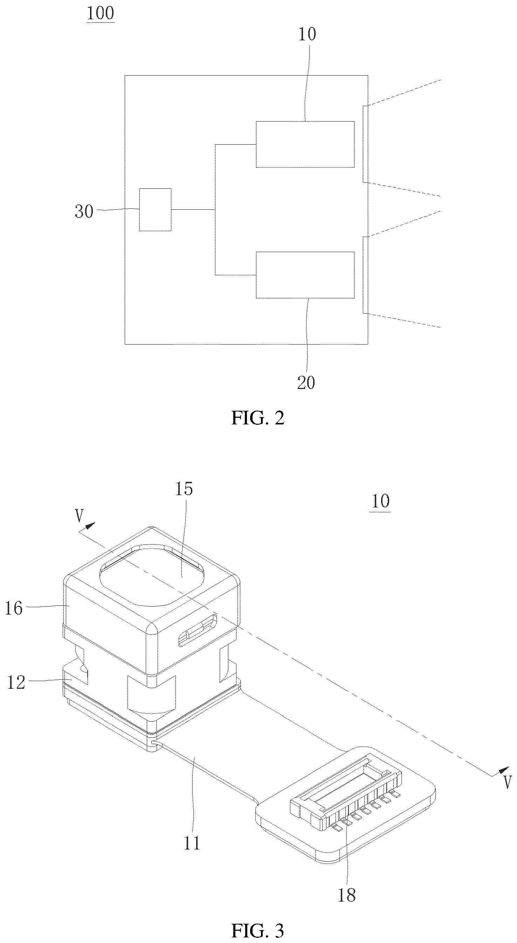

Specifically, referring to FIG. 1 and FIG. 2, the electronic device 1000 includes the housing 200 and the depth camera 100. The electronic device 1000 may be a mobile phone, a tablet computer, a smart watch, a head-mounted display device, a game console, a notebook computer, etc. The present disclosure takes the electronic device 1000 being a mobile phone as an example for description, but it can be understood that a specific form of the electronic device 1000 is not limited to the mobile phone.

The housing 200 can be used as a mounting carrier for functional elements of the electronic device 1000, and provide protection against dust, water, and drop for the functional elements. The functional elements can be elements including a display screen 400, a visible light camera 300, the depth camera 100, a main board, a power module, etc. of the electronic device 1000. The housing 200 includes a front surface 201 and a rear surface 202 that are opposite to each other, and the functional elements may be mounted on the front surface 201 or the rear surface 202. As illustrated in FIG. 1, the display screen 400 is mounted on the housing 200 and located on the front surface 201, the visible light camera 300 is mounted on the housing 200 and located on the rear surface 202, and the depth camera 100 is mounted on the housing and located on the rear surface 202. In this case, the visible light camera 300 can serve as a rear camera, and the depth camera 100 can serve as a rear depth camera. Here, the visible light camera 300 may include one or more of a telephoto camera, a wide-field camera, a periscope camera, a monochrome camera, and the like; and the display screen 400 may be a liquid crystal display screen, an Organic Light-Emitting Diode (OLED) display screen, a Micro Led display screen, or other display screens 400.

Of course, in other embodiments, mounting positions of the display screen 400, the visible light camera 300, and the depth camera 100 on the housing 200 may be arranged in other manners. For example, the display screen 400 can be arranged on both the front surface 201 and the rear surface 202, the visible light camera 300 can be mounted on the front surface 201 and used as a front camera, and the depth camera 100 can be mounted on the rear surface 202 and used as a rear depth camera. In addition, the visible light camera 300 can be alternatively arranged below the display screen 400, i.e., the visible light camera 300 is configured to receive light passing through the display screen 400 for imaging; and the depth camera 100 can be alternatively arranged below the display screen 400, a light signal emitted by the depth camera 100 passes through the display screen 400 and then enters an outside of the electronic device 1000, and the depth camera 100 is configured to receive a light signal that has passed through the display screen 400 from the outside of the electronic device 1000 to obtain a depth.

Referring to FIG. 1 and FIG. 2, the depth camera 100 is mounted on the housing 200, and the present disclosure takes the depth camera 100 being located on the rear surface 202 of the housing 200 as an example for description. The depth camera 100 may obtain a depth by using a principle of structured light ranging, or obtain a depth by using a principle of Time of Flight (TOF) ranging. The embodiments of the present disclosure take the depth camera 100 being configured to obtain a depth by using the principle of structured light ranging as an example for description. The depth camera 100 includes the laser projector 10, the image collector 20, and a processor 30.

Referring to FIG. 3 to FIG. 5, the laser projector 10 is configured to project light onto the target object, and the light can be infrared laser. Laser light projected by the laser projector 10 onto the target object may have a specific pattern, the pattern may be a speckle pattern, a stripe pattern, etc., and a laser pattern formed by the laser light after being reflected by the target object is related to a distance from the target object. The laser projector 10 includes the substrate 11, the lens barrel 12, the light source 13, and the diffraction assembly 15.

The substrate 11 may include a circuit board and a reinforcing plate. The circuit board can be any one of a printed circuit board, a flexible circuit board, and a rigid-flex board. A part of the circuit board is covered by the lens barrel 12, and the other part of the circuit board extends beyond the lens barrel 12 and can be connected to a connector 18. The connector 18 can connect the laser projector 10 with a main board of the electronic device 1000. The reinforcing plate can be used in combination with the circuit board to increase the overall strength of the substrate 11, and for example, the reinforcing plate may be made of materials such as steel.

Referring to FIG. 3 to FIG. 5, the lens barrel 12 is arranged on the substrate 11, and the lens barrel 12 and the substrate 11 define the accommodating chamber 121. The lens barrel 12 may be in a hollow cylindrical shape as a whole, and a side wall 123 of the lens barrel 12 defines the accommodating chamber 121. The lens barrel 12 can be connected to the circuit board of the substrate 11. The lens barrel 12 and the circuit board can be bonded to each other by an adhesive to improve air tightness of the accommodating chamber 121. The accommodating chamber 121 can be used to accommodate elements and components such as the light source 13, and forms a part of the optical path of the laser projector 10. In the embodiments of the present disclosure, the lens barrel 12 may further have a mounting chamber 122 formed. The mounting chamber 122 is in communication with the accommodating chamber 121, and the mounting chamber 122 can be used for mounting of the diffraction assembly 15.

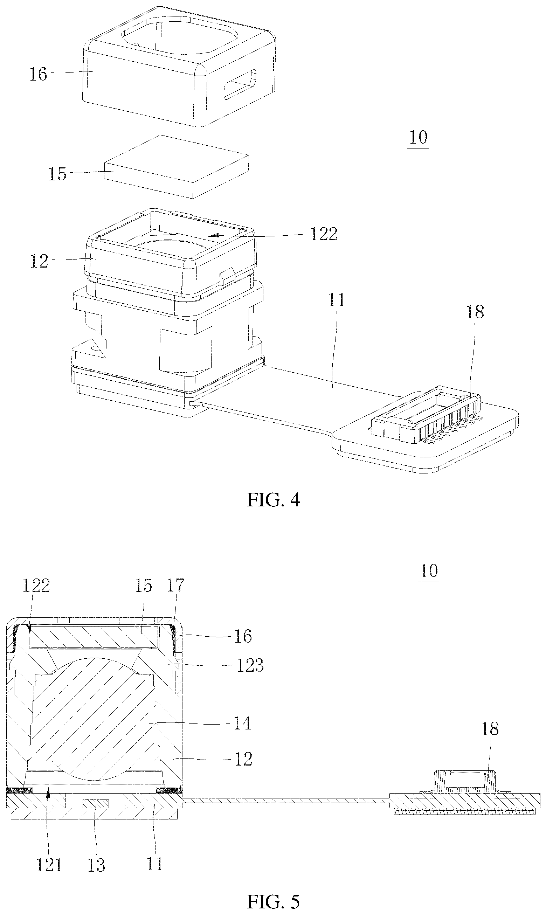

Referring to FIG. 5 and FIG. 6, the light source 13 is configured to emit laser light, the light source 13 is arranged on the substrate 11, and the light source 13 is located in the accommodating chamber 121. Specifically, the light source 13 may be a Vertical Cavity Surface Emitting Laser (VCSEL), and may be arranged on and connected to the circuit board. In the embodiments of the present disclosure, the light source 13 includes an underlayer 132 and a plurality of light-emitting units 131 arranged on the underlayer 132. Each of the plurality of light-emitting units 131 is independently controllable, e.g., light emission or not of each of the plurality of light-emitting units 131 is independently controllable, a light emission power of each of the plurality of light-emitting units 131 is independently controllable, etc. The plurality of light-emitting units 131 may be irregularly arranged on the underlayer 132, in such a manner that a specific pattern has high irrelevance. The plurality of light-emitting units 131 is divided into a plurality of groups, light-emitting units 131 in a same group of the plurality of groups is configured to emit light simultaneously, and a light emission state of light-emitting units 131 of one group of the plurality of groups is different from a light emission state of light-emitting units 131 of another group of the plurality of groups. For example, when a distance to the target object is short, a certain group of the plurality of groups of light-emitting units 131 can be controlled to emit light while the remaining groups of the plurality of groups of light-emitting units 131 can be controlled not to emit light; and when the distance to the target object is long, all of the plurality of groups of light-emitting units 131 can be controlled to emit light to increase energy of laser light irradiated onto the target object.

A divergent angle α of each of the plurality of light-emitting units 131 is smaller than 20 degrees. For example, the divergent angle of each of the plurality of light-emitting units 131 is any angle smaller than 20 degrees, e.g., 19 degrees, 15 degrees, 11.5 degrees, 10 degrees, 7 degrees, 5 degrees, and 3 degrees. When the divergent angle of each of the plurality of light-emitting units 131 is smaller than 20 degrees, a divergent angle of laser light diffracted and then projected by the diffraction assembly 15 will not be too large divergent angle, and even if the distance to the target object is long, an irradiation range of the laser light will not be too large, the energy density of the laser light irradiated onto the target object will not be too small, and the laser light will not be easily interfered by external light. Different light-emitting units 131 have different divergent angles. A range of divergent angles of light-emitting units 131 of a first portion of the plurality of light-emitting units 131 is a first range, a range of divergent angles of light-emitting units 131 of a second portion of the plurality of light-emitting units 131 is a second range, a range of divergent angles of light-emitting units 131 of a third portion of the plurality of light-emitting units 131 is a third range, ..., and a range of divergent angles of light-emitting units 131 of an N-th portion of the plurality of light-emitting units 131 is an N-th range; and each of the first range, the second range, the third range, ..., and the N-th range is with a range smaller than 20 degrees. In this case, when the distance to the target object is short, light-emitting units 131 having relatively large divergent angles are controlled to emit light to diverge energy of laser light and avoid harming a user; and when the distance to the target object is long, light-emitting units 131 having relatively small divergent angles are controlled to emit light, such that laser light projected onto the target object has a high energy density and is not easily interfered.

Referring to FIG. 3 to FIG. 5, the diffraction assembly 15 is mounted on the lens barrel 12 and is located on an optical path of the light source 13. Specifically, the diffraction assembly 15 is mounted in the mounting chamber 122, and laser light emitted by the light source 13 is projected out of the laser projector 10 after passing through the diffraction assembly 15. A diffraction structure is formed on the diffraction assembly 15, and can be configured to diffract the laser light to form the above-mentioned specific pattern.

Referring to FIG. 2, the image collector 20 is configured to collect the laser pattern projected by the laser projector 10 onto the target object and reflected by the target object. Specifically, after the laser light, which has a specific pattern, emitted by the laser projector 10 is projected onto the target object, the laser light is reflected by the target object, and the image collector 20 receives the reflected laser light to obtain the laser pattern. It can be understood that since the reflected laser pattern is related to depth information of the target object, and the reflected laser pattern actually already contains the depth information of the target object. Due to the high energy density of the laser light projected by the laser projector 10 onto the target object, the laser light is not easily interfered by, for example, infrared light in the environment, as a result, the laser pattern collected by the image collector 20 has a high signal-to-noise ratio, which facilitates subsequent obtaining of accurate depth information.

After the processor 30 obtains the laser pattern collected by the image collector 20, the processor 30 processes the laser pattern in accordance with pre-stored calibration information to further obtain the depth information of the target object. Here, the processor 30 may be an application processor 30 of the electronic device 1000, or an external processing chip.

In summary, in the electronic device 1000 according to the embodiments of the present disclosure, a divergent angle of each light-emitting unit 131 is smaller than 20 degrees, light projected by the diffraction assembly 15 after passing through the diffraction assembly 15 has a small divergent angle, and the energy density of the light projected onto a far distant target object is not too small, and thus the light is not easily interfered. Therefore, the finally-obtained depth information is accurate, which gives the user good experience when the user applies the depth information in games (such as Augmented Reality (AR) games), modeling (such as three-dimensional (3D) modeling), and measurements (such as an application in an AR ruler).

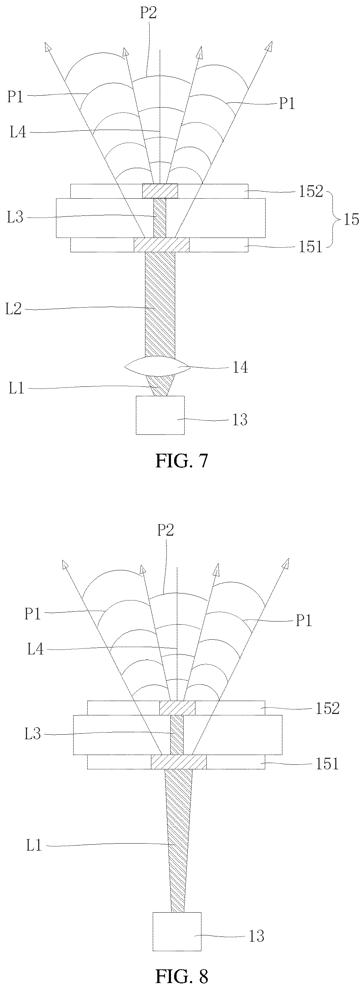

Referring to FIG. 5 and FIG. 7, in some embodiments, the laser projector 10 further includes a collimating element 14. The collimating element 14 can be mounted in the accommodating chamber 121 and located between the light source 13 and the diffraction assembly 15. The laser light enters the diffraction assembly 15 after passing through the collimating element 14. The collimating element 14 may be an optical lens, and configured to collimate the laser light emitted by the light source 13 to make the divergent angle of the laser light projected by the laser projector 10 smaller. In an example, the laser light emitted by the light source 13, after being processed by the collimating element 14, is incident on the diffraction assembly 15 in a state of parallel light.

Referring to FIG. 6 and FIG. 8, when a divergent angle of each of the plurality of light-emitting units 131 is smaller than 7 degrees, light emitted by the light-emitting units 131 directly reaches the diffraction assembly 15. In this case, the divergent angle of each of the plurality of light-emitting units 131 may be any angle smaller than 7 degrees, such as 6 degrees, 5 degrees, and 3 degrees. The collimating element 14 may be omitted to reduce structural complexity and a size of the laser projector 10.

Referring to FIG. 5, in some embodiments, the laser projector 10 further includes a protective cover 16 that covers the lens barrel 12. The protective cover 16 is configured to limit the diffraction assembly 15 mounted on the lens barrel 12, and a gap between the protective cover 16 and an outer wall of the lens barrel 12 is sealed by a sealant 17.

The protective cover 16 covers on the lens barrel 12, and the protective cover 16 can be connected to the side wall 123 through a buckle, such that the protective cover 16 will not be separated from the lens barrel 12 during normal use. The diffraction assembly 15 is mounted in the mounting chamber 122, and the protective cover 16 protects the diffraction assembly 15, in such a manner that a release of the diffraction assembly 15 from the mounting chamber 122 can be avoided, thereby preventing the laser light emitted by the light source 13 from being transmitted without passing through the diffraction assembly 15 and harming the user. The sealant 17 can be dispensed in the gap between the protective cover 16 and the side wall 123 after the protective cover 16 covers on the lens barrel 12, and the sealant 17 is filled between the protective cover 16 and the side wall 123 and surrounds the lens barrel 12, thereby preventing a liquid or dust from entering the diffraction structure of the diffraction assembly 15 through the gap between the protective cover 16 and the side wall 123, preventing zero-order enhancement resulted from a damage to the diffraction structure, and improving use safety of the laser projector 10.

Referring to FIG. 7, in some embodiments, the diffraction assembly 15 includes a first diffraction element 151 and a second diffraction element 152. The first diffraction element 151 is configured to diffract laser light to form a first zero-order light beam L3, and the second diffraction element 152 is configured to diffract the first zero-order light beam L3 to form a second zero-order light beam L4.

Laser light L1 emitted by the light source 13 is collimated by the collimating element 14 to form laser light L2. The first diffraction element 151 includes a first optically effective region and a first non-optically effective region. The first optically effective region is configured to correspond to a cross section of the laser light L2 collimated by the collimating element 14. A diffraction grating is arranged on the first optically effective region, and the laser light L2 collimated by the collimating element 14 forms a first laser pattern P1 and the first zero-order light beam L3 after passing through the diffraction grating. The second diffraction element 152 includes a second optically effective region and a second non-optically effective region. The second optically effective region is configured to correspond to a cross section of the first zero-order light beam L3, and the second optically effective region has a diffraction grating provided thereon. The first zero-order light beam L3 forms a second laser pattern P2 and the second zero-order light beam L4 after passing through the diffraction grating. The second non-optically effective region is a transparent portion having no diffraction grating provided, which transmits the first laser pattern P1 without changing a pattern style of the first laser pattern P1. The diffraction grating of the first optically effective region has a different grating structure from that of the diffraction grating of the second optically effective region, which enables the first laser pattern P1 and the second laser pattern P2 to have high irrelevance. The first laser pattern P1 is combined with the second laser pattern P2 to form a complete specific pattern to be projected by the laser projector 10. When the first laser pattern P1 and the second laser pattern P2 are projected onto a plane perpendicular to an optical axis of the laser projector 10, the first laser pattern P1 may partially overlap the second laser pattern P2 to further enhance the irrelevance of the specific pattern.

Compared with a diffraction assembly using one diffraction element, the structure of the diffraction assembly 15 using two diffraction elements can further diffract the zero-order light beam, and accordingly, reduce the energy of the zero-order light beam. In this case, a specific pattern projected by the laser projector 10 using the two diffraction elements has good brightness uniformity, and can also avoid damages to the eyes of the user due to the strong energy of the zero-order light beam. In this way, although the laser light projected by the laser projector 10 has a small divergent angle, no region having too-concentrated energy will be generated, thereby improving the use safety of the laser projector 10.

Referring to FIG. 8, when the collimating element 14 is omitted, the laser light L1 emitted by the light source 13 is directly irradiated on the first optically effective region, and a diffraction effect of the diffraction assembly 15 on the laser light L1 is similar to that in the example illustrated in FIG. 7, details of which will be omitted here.

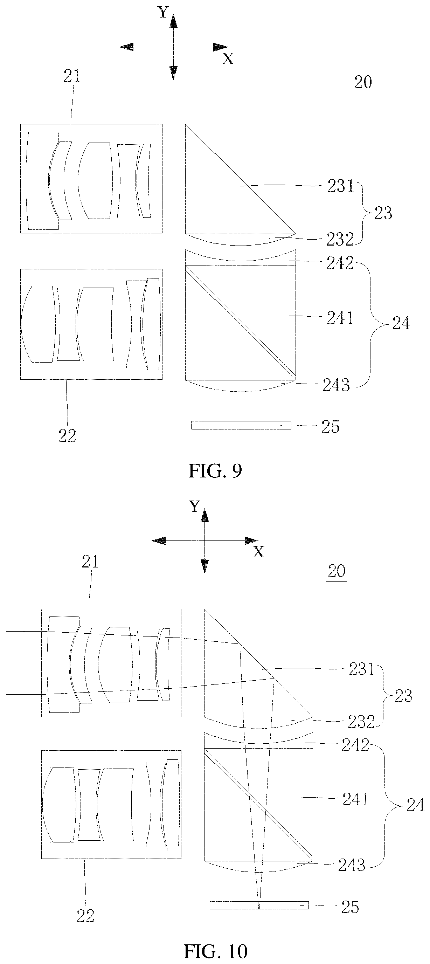

Referring to FIG. 9 to FIG. 11, in some embodiments, the image collector 20 includes a first lens group 21, a second lens group 22, a reflection prism 23, a reflection-transmission prism 24, and a photosensitive member 25. Here, an optical axis of the first lens group 21 and an optical axis of the second lens group 22 are both in a first direction (direction X in FIG. 9 to FIG. 11) and are parallel to each other. The reflection-transmission prism 24 is switchable between a transmission mode and a reflection mode.

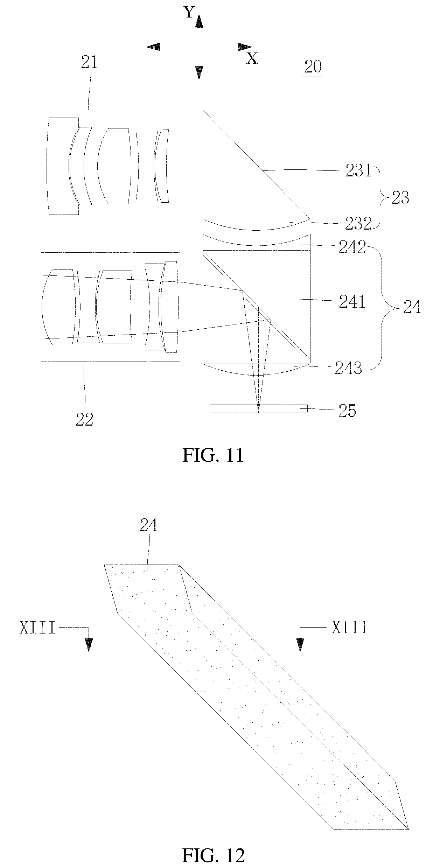

In an example illustrated in FIG. 10, when the reflection-transmission prism 24 is in the transmission mode, light rays entering the image collector 20 from the first lens group 21 are reflected by the reflection prism 23 to a second direction (direction Y in FIG. 9 to FIG. 11) and then transmitted through the reflection-transmission prism 24 to form a first optical path, and the light rays pass through the first lens group 21, the reflection prism 23, and the reflection-transmission prism 24 along the first optical path and then reach the photosensitive member 25. In an example illustrated in FIG. 11, when the reflection-transmission prism 24 is in the reflection mode, light rays entering the image collector 20 from the second lens group 22 are reflected by the reflection-transmission prism 24 to the second direction to form a second optical path, and the light rays pass through the second lens group 22 and the reflection-transmission prism 24 along the second optical path and then reach a photosensitive unit 251. The second direction may be different from the first direction. In one example, the second direction is perpendicular to the first direction.

The reflection prism 23 includes a reflection prism body 231 and a first attachment lens 232. One or more first attachment lenses 232 may be provided. The first attachment lens 232 may be adhered to the reflection prism body 231, and the first attachment lens 232 and the reflection prism body 231 may be alternatively formed as one piece. The reflection-transmission prism 24 includes a reflection-transmission prism body 241, a first additional lens 242, and a second additional lens 243. One or more first additional lenses 242 and one or more second additional lenses 243 may be provided. The first additional lens 242 and the second additional lens 243 may be adhered to the reflection-transmission prism body 241, and the first additional lens 242, the second additional lens 243, and the reflection-transmission prism body 241 may be alternatively formed as one piece.

Referring to FIG. 9 and FIG. 10, the first lens group 21, the reflection prism body 231, the first attachment lens 232, the first additional lens 242, the reflection-transmission prism body 241, and the second additional lens 243 form a lens combination having a first focal length for the first optical path; and referring to FIG. 9 and FIG. 11, the second lens group 22, the reflection-transmission prism body 241, and the second additional lens 243 form a lens combination having a second focal length for the second optical path. The first focal length is different from the second focal length. When in use, a light-shielding sheet (not illustrated) can be provided on each of the first lens group 21 and the second lens group 22. When the first focal length needs to be used for focusing, the light-shielding sheet is driven to shield the second lens group 22 to enable light to enter the image collector 20 from the first lens group 21; and when the second focal length needs to be used for focusing, the light-shielding sheet is driven to shield the first lens group 21 to enable light to enter the image collector 20 from the second lens group 22. In this manner, the user can switch the focal length of the image collector 20 based on the distance to the target object, so as to obtain clear laser patterns in more scenes.

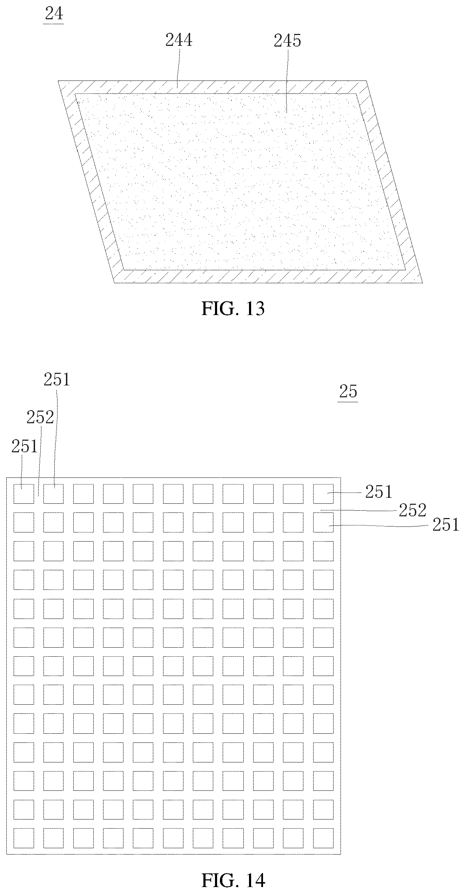

Referring to FIG. 12 and FIG. 13, in some embodiments, the reflection-transmission prism 24 includes a light-transmissive container 244 and a liquid crystal material layer 245 arranged in the light-transmissive container 244. The liquid crystal material layer 245 can switch the reflection-transmission prism 24 between the reflection mode and the transmission mode under an action of an electrical signal. The liquid crystal material layer 245 may use a nematic liquid crystal material, a cholesteric liquid crystal material, or the like. In some embodiments, the liquid crystal material layer 245 is in a reflection state when no electrical signal appears. That is, when not energized, the reflection-transmission prism 24 is in the reflection mode. When an electrical signal is input, the liquid crystal material layer 245 is in a transmission state. That is, when energized, the reflection-transmission prism 24 is in the transmission mode. Here, the electrical signal can be a current signal or a voltage signal.

In an example, the liquid crystal material layer 245 adopts the cholesteric liquid crystal material composed of a chiral dopant and nematic liquid crystals. In the presence of the chiral dopant, when the reflection-transmission prism 24 is in the reflection mode, each molecule of the nematic liquid crystals is elongated along a longitudinal molecular axis of the molecule to form a helical arrangement. When the reflection-transmission prism 24 is in the transmission mode, molecules of the nematic liquid crystals, instead of being arranged, are in a dispersed state, and thus the cholesteric liquid crystal material layer 245 becomes light transmissive. Molecular dispersion or molecular arrangement causes the cholesteric liquid crystal material layer 245 to be switched between the reflection state and the transmission state.

Referring to FIG. 14, the photosensitive member 25 can be configured to generate an electrical signal based on the received laser light. Specifically, a quantity of the generated electrical signals increases as the intensity of the received laser light increases. The photosensitive member 25 can be made of a material having high quantum efficiency for laser light (for example, infrared light having a wavelength of 940 nm) to improve the efficiency of the photosensitive member 25 generating electrical signals after receiving the laser light, and increase a signal-to-noise ratio of a laser pattern obtained by the image collector 20.

The photosensitive member 25 includes a plurality of photosensitive units 251, and every two adjacent photosensitive units 251 of the plurality of photosensitive units 251 have an isolation trench 252 defined therebetween. The plurality of photosensitive units 251 may be arranged in an array, e.g., in a matrix of a plurality of rows and a plurality of columns. The isolation trench 252 may be made by a Shallow Trench Isolation (STI) process or a Deep Trench Isolation (DTI) process, so as to prevent crosstalk of the laser light between adjacent photosensitive units 251, and improve accuracy of the laser pattern collected by the image collector 20. Further, a spacer may be provided on the isolation trench 252 to further block the propagation of the laser light between adjacent photosensitive units 251.

In an example, a wavelength of laser light emitted by each of the plurality of light-emitting units 131 ranges from 1,350 nanometers to 1,550 nanometers, and the photosensitive member 25 is made of a germanium-silicon material. The photosensitive member 25 made of the germanium-silicon material has a high quantum efficiency for light having a wavelength ranging from 1,350 nanometers to 1,550 nanometers. Moreover, since light rays of the natural environment include a relatively small number of light rays having a wavelength ranging from 1,350 nanometers to 1,550 nanometers, the laser light emitted by the light-emitting unit 131 is not easily interfered by ambient light, such that a signal-to-noise ratio of the laser pattern collected by the image collector 20 can be improved.

In the description of this specification, descriptions with reference to the terms "some embodiments", "an embodiment", "illustrative embodiments", "examples", "specific examples", or "some examples" etc. mean that specific features, structures, materials or characteristics described in conjunction with the embodiment or example are included in at least one embodiment or example of the present disclosure. In this specification, the schematic representations of the above terms do not necessarily refer to the same embodiment or example. Moreover, the described specific features, structures, materials or characteristics can be combined in any one or more embodiments or examples in a suitable manner.

In addition, the terms "first" and "second" are only used for descriptive purposes, and cannot be understood as indicating or implying relative importance or implicitly indicating the number of indicated technical features. Therefore, the features defined with "first" and "second" may explicitly or implicitly include at least one of the features. In the description of the present disclosure, "plurality" means at least two, such as two, three, etc., unless otherwise specifically defined.

## Claims

1. A laser projector (10), comprising:
a substrate (11);
a lens barrel (12) arranged on the substrate (11), wherein the lens barrel (12) and the substrate (11) define an accommodating chamber (121);
a light source (13) arranged on the substrate (11) and located in the accommodating chamber (121), the light source (13) comprising a plurality of light-emitting units (131), wherein a divergent angle of each of the plurality of light-emitting units (131) is smaller than 20 degrees; and
a diffraction assembly (15) mounted on the lens barrel (12) and located on an optical path of the light source (13),
**characterized in that**, the plurality of light-emitting units (131) is divided into a plurality of portions, and a divergent angle of each light-emitting unit (131) in one portion of the plurality of portions is different from a divergent angle of each light-emitting unit (131) in another portion of the plurality of portions.

2. The laser projector (10) according to claim 1, wherein the divergent angle of each of the plurality of light-emitting units (131) is smaller than 7 degrees, and light emitted by the light-emitting unit (131) directly reaches the diffraction assembly (15).

3. The laser projector (10) according to claim 1, wherein the diffraction assembly (15) comprises a first diffraction element (151) configured to diffract laser light to form a first zero-order light beam (L3) and a second diffraction element (152) configured to diffract the first zero-order light beam to form a second zero-order light beam (L4).

4. The laser projector (10) according to claim 1, further comprising a protective cover (16) that covers the lens barrel (12), wherein the cover (16) is configured to limit the diffraction assembly (15) mounted on the lens barrel (12), and a gap between the protective cover (16) and an outer wall of the lens barrel (12) is sealed by a sealant (17).

5. The laser projector (10) according to claim 1, wherein light emission or not of each of the plurality of light-emitting units (131) is independently controllable; and/or
a light emission power of each of the plurality of light-emitting units (131) is independently controllable.

6. A depth camera (100), comprising:
the laser projector (10) according to any one of claims 1-5; and
an image collector (20) configured to collect a laser pattern projected by the laser projector (10) onto a target object and reflected by the target object.

7. The depth camera according to claim 6, wherein a wavelength of laser light emitted by each of the plurality of light-emitting units (131) ranges from 1,350 nanometers to 1,550 nanometers, the image collector (20) comprises a photosensitive member (25) configured to generate an electrical signal based on received laser light, and the photosensitive member (25) is made of a germanium-silicon material.

8. The depth camera according to claim 6, wherein the image collector (20) comprises a photosensitive member (25) configured to generate an electrical signal based on received laser light, the photosensitive member (25) comprises a plurality of photosensitive units (251), and every two adjacent photosensitive units of the plurality of photosensitive units (251) have an isolation trench (252) defined therebetween.

9. The depth camera according to claim 6, wherein the image collector (20) comprises a first lens group (21), a second lens group (22), a reflection prism (23), and a reflection-transmission prism (24), and an optical axis of the first lens group (21) and an optical axis of the second lens group (22) are both in a first direction and are parallel to each other; and the reflection-transmission prism (24) is switchable between a transmission mode and a reflection mode;
when the reflection-transmission prism (24) is in the transmission mode, light rays entering the image collector (20) from the first lens group (21) are reflected by the reflection prism (23) to a second direction and then transmitted through the reflection-transmission prism (24) to form a first optical path, the first direction being different from the second direction; and
when the reflection-transmission prism (24) is in the reflection mode, light entering the image collector (20) from the second lens group (22) is reflected by the reflection-transmission prism (24) to the second direction to form a second optical path.

10. The depth camera according to claim 9, wherein the reflection prism (23) comprises a reflection prism body (231) and a first attachment lens (232), the reflection-transmission prism (24) comprises a reflection-transmission prism body (241), a first additional lens (242), and a second additional lens (243), the first lens group (21), the reflection prism body (231), the first attachment lens (232), the first additional lens (242), the reflection-transmission prism body (241), and the second additional lens (243) form a lens combination having a first focal length for the first optical path, and the second lens group (22), the reflection-transmission prism body (241), and the second additional lens (243) form a lens combination having a second focal length for the second optical path, the first focal length being different from the second focal length.

11. The depth camera according to claim 6, being configured to:
obtain a depth by using a principle of structured light ranging; or
obtain the depth by using a principle of Time of Flight ranging.

12. An electronic device (1000), comprising:
a housing (200) comprising a front surface (201) and a rear surface (202) that are opposite to each other;
a display screen (400) mounted on the housing (200) and located on the front surface (201) of the housing (200); and
the depth camera (100) according to any one of claims 6 to 11, the depth camera (100) being mounted on the housing (200) and located on the rear surface (202) of the housing (200).

## Patentansprüche

1. Laserprojektor (10), der Folgendes umfasst:
ein Substrat (11);
einen Linsentubus (12), der auf dem Substrat (11) angeordnet ist, wobei der Linsentubus (12) und das Substrat (11) eine Aufnahmekammer (121) definieren;
eine Lichtquelle (13), die auf dem Substrat (11) angeordnet ist und sich in der Aufnahmekammer (121) befindet, wobei die Lichtquelle (13) mehrere Lichtemissionseinheiten (131) umfasst, wobei ein Divergenzwinkel jeder der mehreren Lichtemissionseinheiten (131) kleiner als 20 Grad ist; und
eine Beugungsbaugruppe (15), die auf dem Linsentubus (12) montiert ist und sich in einem optischen Pfad der Lichtquelle (13) befindet,
**dadurch gekennzeichnet, dass** die mehreren Lichtemissionseinheiten (131) in mehrere Teile unterteilt sind und sich ein Divergenzwinkel jeder Lichtemissionseinheit (131) in einem Teil der mehreren Teile von einem Divergenzwinkel jeder Lichtemissionseinheit (131) in einem anderen Teil der mehreren Teile unterscheidet.

2. Laserprojektor (10) nach Anspruch 1, wobei der Divergenzwinkel jeder der mehreren Lichtemissionseinheiten (131) kleiner als 7 Grad ist und Licht, das durch die Lichtemissionseinheit (131) emittiert wird, die Beugungsbaugruppe (15) direkt erreicht.

3. Laserprojektor (10) nach Anspruch 1, wobei die Beugungsbaugruppe (15) ein erstes Beugungselement (151), das dazu konfiguriert ist, Laserlicht zu beugen, um einen ersten Lichtstrahl (L3) nullter Ordnung zu bilden, und ein zweites Beugungselement (152), das dazu konfiguriert ist, den ersten Lichtstrahl nullter Ordnung zu beugen, um einen zweiten Lichtstrahl (L4) nullter Ordnung zu bilden, umfasst.

4. Laserprojektor (10) nach Anspruch 1, der ferner eine Schutzabdeckung (16) umfasst, die den Linsentubus (12) bedeckt, wobei die Abdeckung (16) dazu konfiguriert ist, die Beugungsbaugruppe (15), die auf dem Linsentubus (12) montiert ist, zu begrenzen, und ein Spalt zwischen der Schutzabdeckung (16) und einer Außenwand des Linsentubus (12) durch ein Versiegelungsmittel (17) versiegelt ist.

5. Laserprojektor (10) nach Anspruch 1, wobei für jede der mehreren Lichtemissionseinheiten (131) unabhängig steuerbar ist, ob eine Lichtemission stattfindet oder nicht; und/oder
eine Lichtemissionsleistung jeder der mehreren Lichtemissionseinheiten (131) unabhängig steuerbar ist.

6. Tiefenkamera (100), die Folgendes umfasst:
den Laserprojektor (10) nach einem der Ansprüche 1-5; und
einen Bilderfassungseinheit (20), die dazu konfiguriert ist, ein Lasermuster zu erfassen, das durch den Laserprojektor (10) auf ein Zielobjekt projiziert und durch das Zielobjekt reflektiert wird.

7. Tiefenkamera nach Anspruch 6, wobei eine Wellenlänge von Laserlicht, das durch jede der mehreren lichtemittierenden Einheiten (131) emittiert wird, im Bereich von 1.350 Nanometer bis 1.550 Nanometer liegt, die Bilderfassungseinheit (20) ein lichtempfindliches Element (25) umfasst, das dazu konfiguriert ist, ein elektrisches Signal basierend auf empfangenem Laserlicht zu erzeugen, und das lichtempfindliche Element (25) aus einem Germanium-Silicium-Material gefertigt ist.

8. Tiefenkamera nach Anspruch 6, wobei die Bilderfassungseinheit (20) ein fotoempfindliches Element (25) umfasst, das dazu konfiguriert ist, ein elektrisches Signal basierend auf empfangenem Laserlicht zu erzeugen, das fotoempfindliche Element (25) mehrere fotoempfindliche Einheiten (251) umfasst und jeweils zwei benachbarte fotoempfindliche Einheiten der mehreren fotoempfindlichen Einheiten (251) einen Isolationsgraben (252) aufweisen, der dazwischen definiert ist.

9. Tiefenkamera nach Anspruch 6, wobei die Bilderfassungseinheit (20) eine erste Linsengruppe (21), eine zweite Linsengruppe (22), ein Reflexionsprisma (23) und ein Reflexion-Transmission-Prisma (24) umfasst und eine optische Achse der ersten Linsengruppe (21) und eine optische Achse der zweiten Linsengruppe (22) beide in einer ersten Richtung sind und parallel zueinander sind; und das Reflexion-Transmission-Prisma (24) zwischen einem Transmissionsmodus und einem Transmissionsmodus umschaltbar ist;
wenn sich das Reflexion-Transmission-Prisma (24) in dem Transmissionsmodus befindet, werden Lichtstrahlen, die von der ersten Linsengruppe (21) in die Bilderfassungseinheit (20) eintreten, durch das Reflexionsprisma (23) in eine zweite Richtung reflektiert und dann durch das Reflexion-Transmission-Prisma (24) transmittiert, um einen ersten optischen Pfad zu bilden, wobei sich die erste Richtung von der zweiten Richtung unterscheidet; und
wenn sich das Reflexion-Transmission-Prisma (24) in dem Reflexionsmodus befindet, wird Licht, das von der zweiten Linsengruppe (22) in die Bilderfassungseinheit (20) eintritt, durch das Reflexion-Transmission-Prisma (24) in die zweite Richtung reflektiert, um einen zweiten optischen Pfad zu bilden.

10. Tiefenkamera nach Anspruch 9, wobei das Reflexionsprisma (23) einen Reflexionsprismakörper (231) und eine erste Befestigungslinse (232) umfasst, das Reflexion-Transmission-Prisma (24) einen Reflexion-Transmission-Prismakörper (241), eine erste zusätzliche Linse (242) und eine zweite zusätzliche Linse (243) umfasst, die erste Linsengruppe (21), der Reflexionsprismakörper (231), die erste Befestigungslinse (232), die erste zusätzliche Linse (242), der Reflexion-Transmission-Prismakörper (241) und die zweite zusätzliche Linse (243) eine Linsenkombination mit einer ersten Brennweite für den ersten optischen Pfad bilden, und die zweite Linsengruppe (22), der Reflexion-Transmission-Prismakörper (241) und die zweite zusätzliche Linse (243) eine Linsenkombination mit einer zweiten Brennweite für den zweiten optischen Pfad bilden, wobei sich die erste Brennweite von der zweiten Brennweite unterscheidet.

11. Tiefenkamera nach Anspruch 6, die zu Folgendem konfiguriert ist:
Erhalten einer Tiefe durch Verwenden eines Prinzips der Entfernungsmessung mit strukturiertem Licht; oder
Erhalten der Tiefe durch Verwenden eines Prinzips der Laufzeitentfernungsmessung.

12. Elektronische Vorrichtung (1000), die Folgendes umfasst:
ein Gehäuse (200), das eine vordere Oberfläche (201) und eine hintere Oberfläche (202) umfasst, die einander gegenüberliegen;
einen Anzeigebildschirm (400), der an dem Gehäuse (200) montiert ist und sich auf der vorderen Oberfläche (201) des Gehäuses (200) befindet; und
die Tiefenkamera (100) nach einem der Ansprüche 6 bis 11, wobei die Tiefenkamera (100) an dem Gehäuse (200) montiert ist und sich auf der hinteren Oberfläche (202) des Gehäuses (200) befindet.

## Revendications

1. Projecteur laser (10) comprenant :
un substrat (11) ;
un barillet de lentille (12) disposé sur le substrat (11), le barillet de lentille (12) et le substrat (11) définissant une chambre de réception (121) ;
une source de lumière (13) disposée sur le substrat (11) et située dans la chambre de réception (121), la source de lumière (13) comprenant une pluralité d'unités électroluminescentes (131), dans lequel un angle de divergence de chacune de la pluralité d'unités électroluminescentes (131) est inférieur à 20 degrés ; et
un ensemble de diffraction (15) monté sur le barillet de lentille (12) et situé sur un chemin optique de la source de lumière (13),
**caractérisé en ce que** la pluralité d'unités électroluminescentes (131) est divisée en une pluralité de parties, et un angle de divergence de chaque unité électroluminescente (131) dans une partie de la pluralité de parties est différent d'un angle de divergence de chaque unité électroluminescente (131) dans une autre partie de la pluralité de parties.

2. Projecteur laser (10) selon la revendication 1, dans lequel l'angle de divergence de chacune de la pluralité d'unités électroluminescentes (131) est inférieur à 7 degrés, et la lumière émise par l'unité électroluminescente (131) atteint directement l'ensemble de diffraction (15).

3. Projecteur laser (10) selon la revendication 1, dans lequel l'ensemble de diffraction (15) comprend un premier élément de diffraction (151) configuré pour diffracter la lumière laser pour former un premier faisceau lumineux d'ordre zéro (L3) et un second élément de diffraction (152) configuré pour diffracter le premier faisceau lumineux d'ordre zéro pour former un second faisceau lumineux d'ordre zéro (L4).

4. Projecteur laser (10) selon la revendication 1, comprenant en outre un capot protecteur (16) qui recouvre le barillet de lentille (12), dans lequel le capot (16) est configuré pour limiter l'ensemble de diffraction (15) monté sur le barillet de lentille (12), et un espace entre le capot protecteur (16) et une paroi extérieure du barillet de lentille (12) est fermé hermétiquement par un produit d'étanchéité (17).

5. Projecteur laser (10) selon la revendication 1, dans lequel l'émission de lumière ou non de chacune de la pluralité d'unités électroluminescentes (131) peut être commandée indépendamment ; et/ou
une puissance d'émission de lumière de chacune de la pluralité d'unités électroluminescentes (131) peut être commandée indépendamment.

6. Caméra de profondeur (100), comprenant :
le projecteur laser (10) selon l'une quelconque des revendications 1-5 ; et
un collecteur d'image (20) configuré pour collecter un motif laser projeté par le projecteur laser (10) sur un objet cible et réfléchi par l'objet cible.

7. Caméra de profondeur selon la revendication 6, dans laquelle une longueur d'onde de lumière laser émise par chacune de la pluralité d'unités électroluminescentes (131) est comprise entre 1 350 nanomètres et 1 550 nanomètres, le collecteur d'image (20) comprend un élément photosensible (25) configuré pour générer un signal électrique sur la base de la lumière laser reçue, et l'élément photosensible (25) est constitué d'un matériau de germanium-silicium.

8. Caméra de profondeur selon la revendication 6, dans laquelle le collecteur d'image (20) comprend un élément photosensible (25) configuré pour générer un signal électrique sur la base d'une lumière laser reçue, l'élément photosensible (25) comprend une pluralité d'unités photosensibles (251), et une unité photosensible adjacente sur deux de la pluralité d'unités photosensibles (251) présente une tranchée d'isolation (252) définie entre elles.

9. Caméra de profondeur selon la revendication 6, dans laquelle le collecteur d'image (20) comprend un premier groupe de lentilles (21), un second groupe de lentilles (22), un prisme de réflexion (23) et un prisme de réflexion-transmission (24), et un axe optique du premier groupe de lentilles (21) et un axe optique du second groupe de lentilles (22) sont tous deux dans une première direction et sont parallèles l'un à l'autre ; et le prisme de réflexion-transmission (24) est commutable entre un mode de transmission et un mode de réflexion-transmission ;
lorsque le prisme de réflexion-transmission (24) est en mode de transmission, les rayons lumineux pénétrant dans le collecteur d'image (20) depuis le premier groupe de lentilles (21) sont réfléchis par le prisme de réflexion (23) dans une seconde direction, puis transmis à travers le prisme de réflexion-transmission (24) pour former un premier chemin optique, la première direction étant différente de la seconde direction ; et
lorsque le prisme de réflexion-transmission (24) est en mode de réflexion, la lumière pénétrant dans le collecteur d'image (20) depuis le second groupe de lentilles (22) est réfléchie par le prisme de réflexion-transmission (24) dans la seconde direction pour former un second chemin optique.

10. Caméra de profondeur selon la revendication 9, dans laquelle le prisme de réflexion (23) comprend un corps de prisme de réflexion (231) et une première lentille interchangeable (232), le prisme de réflexion-transmission (24) comprend un corps de prisme de réflexion-transmission (241), une première lentille supplémentaire (242) et une seconde lentille supplémentaire (243), le premier groupe de lentilles (21), le corps de prisme de réflexion (231), la première lentille interchangeable (232), la première lentille supplémentaire (242), le corps de réflexion-transmission (241) et la seconde lentille supplémentaire (243) forment une combinaison de lentilles présentant une première distance focale pour le premier chemin optique, et le second groupe de lentilles (22), le corps de prisme de transmission-réflexion (241) et la seconde lentille supplémentaire (243) forment une combinaison de lentilles présentant une seconde distance focale pour le second chemin optique, la première distance focale étant différente de la seconde distance focale.

11. Caméra de profondeur selon la revendication 6, laquelle est configurée pour :
obtenir une profondeur en utilisant un principe de télémétrie par lumière structurée ; ou
obtenir la profondeur en utilisant un principe de télémétrie par temps de vol.

12. Dispositif électronique (1000), comprenant :
un boîtier (200) comprenant une surface avant (201) et
une surface arrière (202) qui sont opposées l'une à l'autre ;
un écran d'affichage (400) monté sur le boîtier (200) et situé sur la surface avant (201) du boîtier (200) ; et
la caméra de profondeur (100) selon l'une quelconque des revendications 6 à 11, la caméra de profondeur (100) étant montée sur le boîtier (200) et située sur la surface arrière (202) du boîtier (200).
